# EUROPÄISCHE PATENTSCHRIFT

(11) **EP 0 427 052 B1**
(45) Veröffentlichungstag und Bekanntmachung des Hinweises auf die Patenterteilung: **31.03.1993**
(21) Anmeldenummer: 90120482.6
(22) Anmeldetag: 25.10.1990
(51) Int. Cl.: H01L 25/13, H01L 25/075, H01L 25/07

(54) **Verfahren zur Herstellung von Hybridschaltungen mit einem Array aus gleichen elektronischen Elementen**
Method of manufacturing hybrid circuits with an array of equal electronic elements
Méthode de fabrication de circuits hybrides avec une matrice d'éléments électroniques du même type

(30) Priorität: 09.11.1989 CH 4068/89
(43) Veröffentlichungstag der Anmeldung: 15.05.1991
(73) Patentinhaber: Oerlikon-Contraves AG, 8052 Zürich (CH)
(72) Erfinder: Frey, Raymond, Dr., CH-8052 Zürich (CH); Glaus, Fredy, CH-5620 Zufikon (CH); Heusler, Fredy, CH-5300 Turgi (CH); Steinmann, Jürg, CH-8880 Walenstadt (CH)
(74) Vertreter: Hunziker, Kurt

(56) Entgegenhaltungen:
- DE-A- 3 621 796
- US-A- 4 845 405
- PATENT ABSTRACTS OF JAPAN, Band 8, Nr. 173 (E-259)[1610], 9. August 1984; & JP-A-59 65 490 (RICOH K.K.) 13-04-1984
- PATENT ABSTRACTS OF JAPAN, Band 10, Nr. 27 (E-378)[2084], 4. Februar 1986; & JP-A-60 187 070 (TOSHIBA K.K.) 24-09-1985
- IEEE TRANSACTIONS ON ELECTRON DEVICES, Band ED-26, Nr. 8, August 1979, Seiten 1182-1186, New York, US; T. NIINA et al.: "A high-brightness GaP green LED flat-panel device for character and TV display"

## Beschreibung

Die Erfindung liegt auf dem Gebiete der Herstellung von elektronischen Hybridschaltungen und umfasst ein Verfahren nach dem Oberbegriff des Patentanspruches 1, mit dem sehr dicht gepackte matrixförmige Anordnungen (Arrays) von elektronischen Funktionselementen hergestellt werden können.

Ein übliches Verfahren für die Herstellung von Hybridschaltungen besteht darin, die einzelne elektronische Funktionselemente enthaltenden Chips auf einem Träger, meist einer mit Leiterbahnen beschichteten Keramikplatte, aufzukleben. Als Klebstoff wird beispielsweise ein mit Silber versetztes Epoxydharz verwendet, welches gleichzeitig eine leitende Verbindung zwischen der Leiterbahn und dem Chip herstellt. Wenn die Klebeverbindung sowohl mechanisch als auch elektrisch garantiert den Anforderungen entsprechen soll, muss eine entsprechende Menge Klebstoff verwendet werden und der Chip muss beim Aufkleben leicht angedrückt werden. Dabei ist es, vor allem bei der Verarbeitung von sehr kleinen Chips wie beispielsweise einzelnen Leuchtdioden wahrscheinlich, dass der Klebstoff seitlich leicht unter dem Chip hervorgedrückt wird. Wenn hervorgedrückte Klebstoffwülste benachbarte Leiterbahnen oder Klebstoffwülste benachbarter Chips berühren, entstehen unerwünschte elektrische Verbindungen. Um dies zu verhindern, muss entweder dafür gesorgt werden, dass benachbarte Leiterbahnen und damit auch benachbarte Chips einen minimalen, durch die zu erwartenden Klebstoffwülste gegebenen Abstand voneinander haben, oder dass der überflüssige Klebstoff in einem nachfolgenden Arbeitsgang entfernt wird. In beiden Fällen ist die erreichbare Packungsdichte beschränkt.

Für die Herstellung von Arrays, die aus alles identischen Funktionselementen bestehen, wird normalerweise die Methode der monolithischen Integration angestrebt, das heisst, es wird ein Chip hergestellt, der bereits alle Funktionseinheiten in der gewünschten Ordnung und Packungsdichte enthält. Elektronische Speicherschaltungen werden bekanntlich auf diese Weise hergestellt. Die monolithische Integration ermöglicht hohe Packungsdichten. Wenn die monolithische Integration aber in bezug auf Ausbeute und Rentabilität vertretbar sein soll, bedingt sie, dass funktionstüchtige Funktionseinheiten mit sehr hoher Ausbeute herstellbar sind und dass wirklich eine sehr hohe Packungsdichte gewünscht wird. Für Chips, die viel Energie und aus physikalischen Gründen deshalb auch relativ viel Fläche benötigen, wird die Ausbeute bei der Herstellung monolithisch integrierter Blöcke zu gering und unrentabel. In vielen Fällen sind aber auch die zu verwendenden Materialien bzw. Herstellverfahren für eine Integration einfach nicht geeignet.

Dies trifft insbesondere für Arrays von Leuchtdioden aus GaAs (GaAs-LEDs) zu, die heute hauptsächlich hergestellt werden durch Aufkleben einzelner LEDs auf den Träger. Die erreichbare Packungsdichte ist dabei in erster Linie ein Problem des Montageverfahrens. Die LEDs haben für eine für das menschliche Auge günstige Leuchtdichte Dimensionen von beispielsweise 0,25 x 0,25 x 0,18mm. Für derart kleine Elemente ist es zwingend, den Klebstoff praktisch auf die ganze Auflagefläche des Elementes aufzubringen, da sonst eine sichere Befestigung nicht gewährleistet ist. Auch bei guter Dosierung und genauer Positionierung des Klebstofftupfens wird beim Aufsetzen der LED ein Teil des Klebstoffes seitlich unter der LED hervorgedrückt und das führt dazu, dass der Flächenbedarf der LED das Doppelte ihrer Auflagefläche erreichen kann, wenn die Klebstoffwülste nicht durch zusätzliche Arbeitsschritte entfernt werden. Der heutige Stand der Technik erlaubt die Herstellung von LED-Arrays mit einem Packungsraster von 1mm, d.h. 1 LED pro mm².

Da in einem LED-Array hergestellt nach dem heute üblichen Verfahren wegen der geringen Packungsdichte nur höchstens ein Viertel der Fläche effektive Lichtfläche ist, werden Bilder, die von solchen LED-Arrays angezeigt werden, vom menschlichen Auge als deutlich aus Lichtpunkten zusammengesetzt empfunden und genügen somit höheren Ansprüchen nicht. Arrays von GaAs-LEDs mit höherer Packungsdichte wären wünschenswert, weil sie höhere Bildqualitäten und Anzeigen von kleinerer Baugrösse und/oder höherem Auflösungsvermögen ermöglichen.

Einen Hinweis darauf, wie überschüssiger Klebstoff daran gehindert werden kann, unerwünschte elektrische Kontakte zu bilden, gibt die JP-A-5965490. Zwischen Leuchtdioden (LED) verlaufen Nuten im Substrat. Letzteres wird nach dem Aufkleben der LED erhitzt, so dass überschüssiger Klebstoff weich wird und in die Nuten fliesst.

Es ist nun Aufgabe der Erfindung, ein Verfahren zur Herstellung von Arrays aufzuzeigen, das die Vorteile der monolithischen Integration (vor allem mögliche höhere Packungsdichte) und diejenigen der Verarbeitung einzelner Chips (vor allem Ausschalten von fehlerhaften Funktionselementen) miteinander vereint. Das Verfahren soll eine bedeutend höhere obere Grenze für die Packungsdichte aufweisen als die herkömmlichen Verfahren (ohne die monolithische Integration). Es soll vor allem den Einfluss von unter den Bauelementen hervorgedrückten Klebstoffwülsten auf die Packungsdichte bedeutend verkleinern, sodass diese dann nur noch von den Unregelmässigkeiten der gesägten Kanten der Bauelemente und von der erreichbaren Positionierungsgenauigkeit abhängt. Das Verfahren soll mit herkömmlichen Materialien und Hilfsmitteln durchführbar sein. Es soll für möglichst viele verschiedene Arten von Chips, aus denen Arrays hergestellt werden, anwendbar sein. Für Arrays, die nur wegen zu geringer Ausbeute an funktionstüchtigen Elementen und dadurch zu hoher Ausschussrate nicht mit monolithischer Integration hergestellt werden, soll das Verfahren die Möglichkeit bieten, einzelne Blöcke Funktionselementen, die aus der monolithischen Integration stammen, weiterverarbeiten zu können, ohne sie zuerst in einzelne Elemente zu zertrennen. Beispielsweise sollen mit dem Verfahren Arrays von GaAs-LEDs oder anderen Elementen derselben Grössenordnung hergestellt werden können mit einem Packungsraster von 0,33mm, d.h. 9 LEDs pro mm².

Diese Aufgabe wird gelöst durch das im kennzeichnenden Teil des Patentanspruches 1 angegebene Merkmal, das im Folgenden detailliert beschrieben werden soll. Die Beschreibung stützt sich auf Figuren und diese zeigen:
- **Figur 1:**: eine schematische Abbildung der Produkte der einzelnen Schritte des erfindungsgemässen Verfahrens für Variante A und Variante B
- **Figur 2:**: Varianten von Kontaktierungsflächen auf der vom Träger abgewandten Seite der LEDs
- **Figur 3:**: eine schematische Abbildung der Produkte der einzelnen Schritte zur Herstellung von Schichtverbindungen auf der vom Träger abgewandten Seite der LEDs
- **Figur 4:**: schematische Abbildungen zur Herstellung von Arrays aus LED-Blöcken.

Das Hauptmerkmal des erfindungsgemässen Verfahrens besteht darin, dass Leiterbahnen, auf die die Chips mit elektrisch leitfähigem Klebstoff aufgeklebt werden sollen, durch Sperrmittel voneinander getrennt werden. Diese Sperrmittel beschränken die Möglichkeit, dass kontakte entstehen zwischen unter dem Chip hervorgedrückten Klebstoffwülsten und benachbarten Leiterbahnen oder Klebstoffwülsten benachbarter Chips. Für die wenigen Fälle, in denen trotzdem solche Kontakte enstehen, wird durch die Sperrmittel ein nachträgliches Trennen des Klebstoffes in den sehr schmalen Zwischenräumen mit herkömmlichen Mitteln ermöglicht.

Das erfindungsgemässe Verfahren soll am Beispiel der Herstellung eines bestimmten GaAs-LED-Arrays erläutert werden. Das Array besteht aus einem Quadrat von 128 x 128 einzelnen käuflichen GaAs-Leuchtdioden mit Abmessungen von 0,25 x 0,25 x 0,18mm. Das Rastermass soll 0,33mm betragen, das heisst, der Abstand zwischen den LEDs beträgt im Mittel 0,08mm. Der Träger ist ein keramikträger, der 128 parallele Leiterbahnen von 0,28mm Breite und 0,05mm Abstand voneinander trägt, die die Zeilen der Matrix bilden. Auf jeder dieser Leiterbahnen sind 128 LEDs mit elektrisch leitendem Klebstoff, wie beispielsweise mit Silber versetztem Epoxydharz, aufgeklebt. Die spaltenweise leitende Verbindung von je 128 LEDs verläuft über der vom Träger abgewandten Oberfläche der LEDs. Dafür haben die LEDs auf dieser Oberfläche Bond-Pads, die mit Multistitch-Bonding oder mit einer Schichtverbindung spaltenweise verbunden sind.

Soll dieses LED-Array nach Verfahren vom Stande der Technik hergestellt werden, entstehen beim Aufkleben der LEDs über den Zwischenräumen von nur 0,05mm zwischen den Leiterbahnen unweigerlich leitende Verbindungen, gebildet aus unter den LEDs hervorgedrücktem Klebstoff. Wird weniger Klebstoff verwendet, um solche Kurzschlüsse zu verhindern, ist er auch nicht mehr über die ganze Fläche der LEDs verteilt, was festigkeitsmässig ungenügend ist. Um einen Kurzschluss nachträglich zu öffnen, muss der Klebstoff bis und mit etwas Keramikmaterial des Trägers weggefräst werden. Es gibt aber kein herkömmliches Werkzeug, das bei einer genügenden Standzeit sowohl das Silber-Epoxy als auch die Keramik fräsen kann. Zudem besteht die Gefahr, dass der Klebstoff verschmiert und die LEDs beschädigt werden.

Das erfindungsgemässe Herstellungsverfahren für ein solches LED-Array läuft in den folgenden 5 Hauptschritten ab:
1. Zwischen den Leiterbahnen auf der Oberseite des Keramikträgers werden Sperrmittel angebracht.
2. Die LEDs werden eine nach der anderen auf die Leiterbahnen aufgeklebt.
3. Leitende Verbindungen zwischen den Leiterbahnen werden durch Messen des Widerstandes der einzelnen Leiterbahnen festgestellt. Dieser Schritt kann in einer Verfahrensvariante auch weggelassen werden.
4. Benachbarte Leiterbahnen zwischen denen leitende Verbindungen entstanden sind, werden durch mechanische Trennung mit herkömmlichen Trennmitteln getrennt. Bei der Verfahrensvariante ohne Schritt 3 werden zwischen allen Leiterbahnen Trennungen durchgeführt, was aufwendiges Lokalisieren der kurzgeschlossenen Leiterbahnen erübrigt.
5. Die Leiterbahnen werden nochmals (für die Verfahrensvariante das erste Mal) auf Kurzschlüsse geprüft. In seltenen Fällen können solche immer noch vorhanden sein, können aber auch andere Ursachen haben als Klebstoffbrücken, sodass solche Arrays Ausschuss sind.
6. Die LEDs werden auf ihrer vom Träger abgewandten Oberseite spaltenweise verbunden.

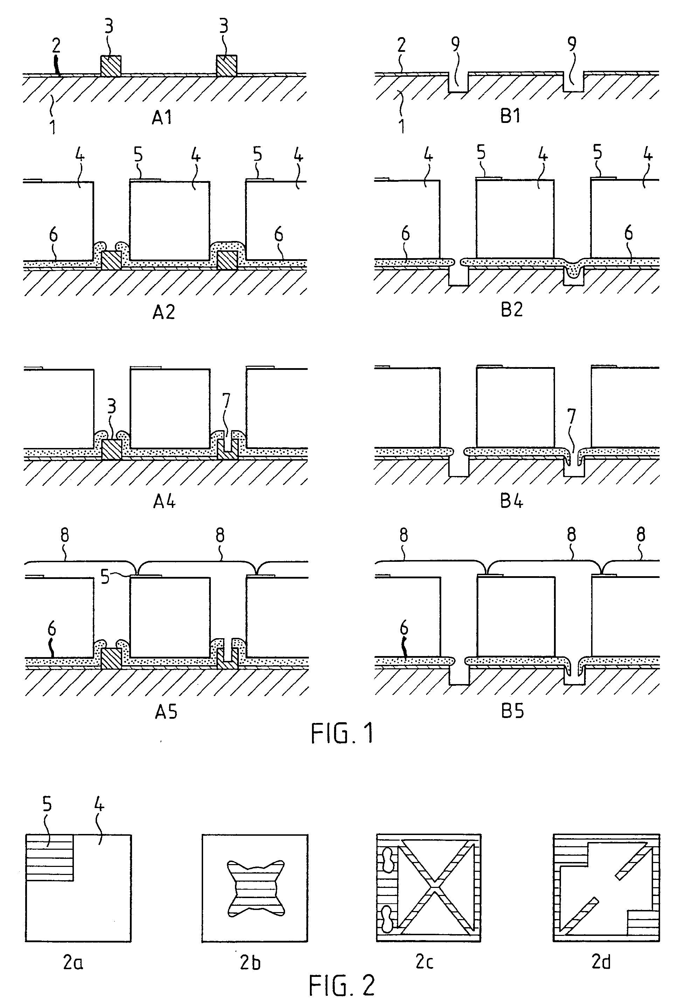

Für den ersten Schritt des erfindungsgemässen Verfahrens stehen zwei Varianten A und B zur Verfügung, die in Figur 1 als Spalten A und B illustriert sind:
A: Auf photochemischem Weg werden auf dem Träger 1 zwischen den Leiterbahnen 2 Barrieren 3 von ca. 0,05 x 0,05mm Querschnitt angebracht (siehe Fig. 1, Teil A1). Das Material der Barrieren muss elektrisch isolierend und für eine mechanische Bearbeitung dem ausgehärteten Klebstoff möglichst ähnlich sein. Zum Beispiel eignet sich als Barrierenmaterial Polyimid.
B: Durch Ausfräsen des Trägermaterials werden zwischen den Leiterbahnen ca. 0,05mm breite und 0,05mm tiefe Nuten 9 ausgehoben (siehe Fig. 1, Teil B1).

Im zweiten Schritt des erfindungsgemässen Verfahrens werden die LEDs 4 eine nach der anderen zwischen den Sperrmitteln auf die Leiterbahnen aufgeklebt. Als elektrisch leitender Klebstoff 6 wird zum Beispiel mit Silber versetztes Epoxydharz verwendet. Trotz der relativ langen Topf-Standzeit des Epoxy-Klebers härtet bzw. trocknet er in kleinen Mengen rasch aus, so dass unmittelbar nach dem Setzen des Tupfens das Bauelement hineingedrückt werden muss. Das heisst mit anderen Worten, das Auftragen des Klebstofftupfens und das Aufsetzten der LED muss für jede LED repetiert werden. Durch das Andrücken der LEDs wird der Kleber seitlich herausgedrückt und zwischen Barriere und LED gestaut, oder er steigt im schlimmsten Fall bis über die Barriere hinaus (siehe Fig. 1, Teil A2). Dieser Klebstoffstau kann sich problematisch auf die Absetzpräzision oder auf andere Verarbeitungsschritte auswirken, sodass in empfindlichen Fällen die Trägervariante mit Nuten 9 vorzugsweise angewendet werden soll. Wenn der Träger zwischen den Leiterbahnen Nuten 9 hat, erhärtet der unter den LEDs hervorgedrückte Klebstoff als Wulst oder Tropfen an der Nutkante. Bei grösseren Mengen wird infolge der Kohäsion und der Oberflächenspannung des Harzes die Nut 9 überbrückt, ohne dass der Klebstoff den Boden der Nut 9 erreicht (siehe Fig. 1, Teil B2).

Im dritten Schritt des erfindungsgemässen Verfahrens werden die Widerstände der einzelnen Leiterbahnen gemessen. Leiterbahnen mit zu kleinem Widerstand sind leitend mit benachbarten Leiterbahnen verbunden und müssen im nächsten Schritt voneinander getrennt werden.

Im vierten Schritt des erfindungsgemässen Verfahrens werden nur kurzgeschlossene oder (als Verfahrensvariante) alle Leiterbahnen durch Fräsenschnitte 7 von ca. 0,03mm Breite voneinander getrennt. Diese Fräsenschnitte werden im Falle der Isoliermaterialbarriere bis ca. 0,03mm tief in die Barriere hinein geschnitten (siehe Fig. 1, Teil A4), im Falle der Nut bis ca. 0,04mm in die Nut hinein (sihe Fig. 1, Teil B4). In beiden Fällen braucht das harte Keramikmaterial des Trägers nicht angefräst zu werden, sodass die Fräsung mit herkömmlichen Fräsenblättern gemacht werden kann, denn die zu fräsenden Materialien sind z.B. Epoxydharz (Klebstoff) und Polyimid (Barriere). Fräsenblätter von wenigen hundertstel Millimetern Breite für solche weichen Materialien sind herstellbar und haben genügende Standzeiten, um wirtschaftlich eingesetzt zu werden, im Gegensatz zu Fräsenblättern zum Fräsen des harten Keramikmaterials des Trägers, die aus Festigkeitsgründen kaum Nuten von weniger als 0,05mm Breite ausheben können.

Im fünften Schritt des erfindungsgemässen Verfahrens werden die Arrays geprüft und Ausschuss ausgeschieden.

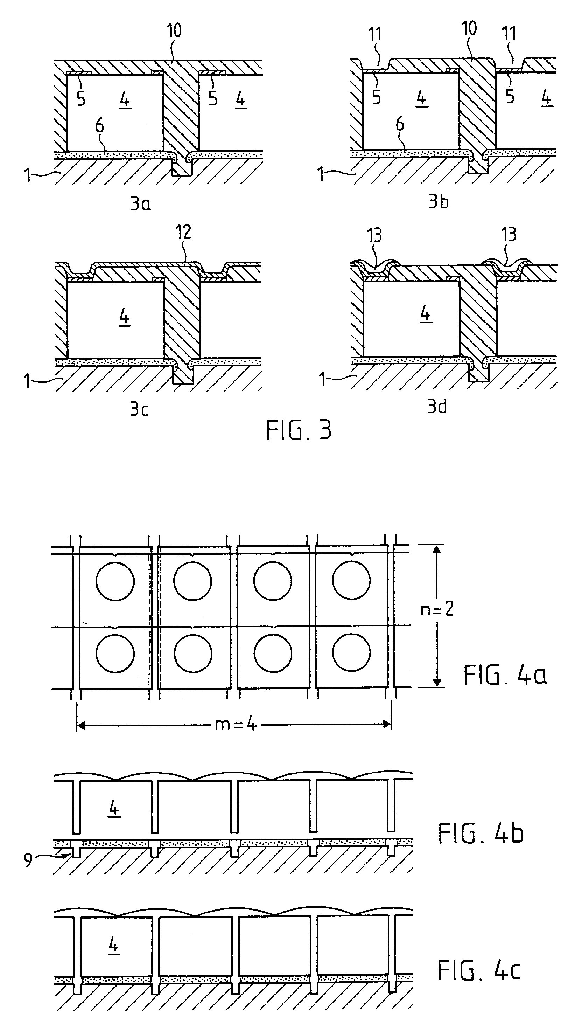

Im sechsten Schritt des erfindungsgemässen Verfahrens werden die LEDs spaltenweise miteinander verbunden. Für diesen Verfahrensschritt stehen zwei Varianten C und D zur Verfügung:
C: Die LEDs besitzen auf ihrer (vom Träger abgewandten) Oberfläche quadratische Kontaktierungsschichten 5, die mit üblichen Bondverfahren mit Draht 8 verbunden werden (siehe Fig. 1, Teil A5 und B5). Der Bondfleck muss eine Grösse von ca. 1/4 der LED-Oberfläche haben, da für die erforderliche Stromstärke und mechanische Festigkeit eine gewisse Dicke der Drähte erforderlich ist und da der Draht beim Ultraschallbonden zerquetscht wird auf ca. 0,05 mm. Die Kontaktstelle muss zudem Platz bieten für zwei Anschlüsse und mit Vorteil noch für einen Reserveanschluss. Ausserdem ist die Kontaktierung so auszulegen, dass sich eine günstige Stromverteilung ergibt. Für die Form der Kontaktierungsflächen auf der Oberfläche der LEDs bieten sich beispielsweise die in Fig. 2 aufgezeigten Mögklichkeiten an. Da die Kontaktierungsflächen und die Bonddrähte einen Teil der Leuchtfläche der LEDs abdecken, verringern sie deren Leuchtkraft. Die in Figur 2c gezeigte einseitig periphere Kontaktierungsschicht beeinträchtigt die Leuchtfläche am wenigsten und wird deshalb bevorzugt. Eine Beinträchtigung der Leuchtfläche kann nur verhindert werden durch Kontaktierungsflächen an den Seitenflächen der LEDs und an den Seitenflächen entlang gezogene Bonddrähte, was aber aus fabrikationstechnischen Gründen mit herkömmlichen Mitteln nicht realisierbar ist. Auch eine Einzelverbindungen jeder LED auf das Substrat würde mehr von der Leuchtfläche der LEDs offen lassen, ist aber bei der Dichte der Anordnung aus Platzmangel nicht möglich.
D: Die einseitig peripheren Kontaktierungsflächen der LEDs (siehe Fig. 2c) werden mit einer Schichtverbindung miteinander verbunden. Besondere Beachtung muss bei der Verfahrensvariante dem Problem der unterschiedlichen Ausdehnungskoeffizienten der verschiedenen Materialien geschenkt werden. Um die Schichtverbindungen herzustellen, sind die folgenden Schritte notwendig, die in der Fig. 3 illustriert sind:
   - Den bestückten Träger mit einem elektrisch isolierenden, transparenten Material 10, beispielsweise Polyimid ausgiessen (siehe Fig. 3a).
   - Auf photochemischem Weg 128 parallele Gräben 11 über den Kontaktierungsschichten freilegen (Sputtering) (siehe Fig. 3b).
   - Array-Oberfläche mit einer Aluminiumschicht 12 beschichten (siehe Fig. 3c).
   - Aluminiumschicht zwischen den Gräben photochemisch wegätzen, sodass nur noch über und zwischen den Kontakttierflächen eine Schichtverbindung aus Aluminium, bedeckt von Photoresist 13 verbleibt (siehe Fig. 3d).

Eine Variante des ganzen bis dahin beschriebenen erfindungsgemässen Herstellungsverfahrens besteht darin, dass anstelle von einzelnen Funktionselementen, zum Beispiel LEDs, integrierte Blöcke von mehreren Funktionselementen, die gleiche oder verschiedene Grössen haben können, verarbeitet werden. Diese Verfahrensvariante wird durch Fig. 4 illustriert. Sie setzt voraus, dass die Funktionselemente, auf dem Wafer in derselben Dichte wie sie für das Array gewünscht ist, zum Beispiel Rastermass 0,33mm, hergestellt werden, was für den Fall der LEDs ohne Schwierigkeiten realisierbar ist. Wäre die Ausbeute an funktionstüchtigen LEDs auf dem Wafer annähernd 100%, könnte ein Waferausschnitt der dem gewünschten Array entspricht (z.B 128 x 128 LEDs) direkt aus dem Wafer geschnitten und auf einen Träger montiert werden und die kritische Montage der vielen einzelnen LEDs würde entfallen. Da aber defekte LEDs auf dem Wafer unvermeidbar sind, bietet sich ein teilweise integriertes Verfahren an, indem Chips in Form von Blöcken von LEDs, die 100% funktionstüchtig sind, aus dem Wafer geschnitten und als solche auf dem Träger aufgesetzt werden. Die Grösse der Blöcke (Chips) ist vorzugsweise m x n LEDs, wobei sowohl m als auch n vorzugsweise Potenzen von 2 oder ganzzahlige Bruchteile der Seitenlängen des herzustellenden Arrays sind (siehe Block in Fig. 4a mit m = 4, n = 2). Die Bestimmung der Blockgrösse erfolgt durch ein geeignetes statistisches Modell, sodass der Wafer abhängig von der Verteilung der defekten LEDs optimal ausgenützt werden kann. Eventuell kann auch innerhalb eines Blockes eine maximale Anzahl defekter Elemente toleriert werden.

Für die Montage von Blöcken, beispielsweise LED-Blöcken mit integrierten Verbindungen, müssen nur für die äussersten LEDs durch Klebstoff Brücken auf die Leiterbahnen auf der Trägerplatte erstellt werden. Bei nicht allzu grossen Blöcken wird dies auch festigkeitsmässig genügen. Wie bei der Montage von einzelnen Elementen besteht aber auch bei dieser Variante des erfindungsgemässen Verfahrens die Gefahr von Kurzschlüssen zwischen den Leiterbahnen bedingt durch den Klebstoff. Wie beim Verfahren mit EinzelLED-Verarbeitung lässt sich aber auch hier der Träger entsprechend vorbereiten, sodass solche Kurzschlüsse nachträglich einfach behoben werden können. Nur die Variante mit den Nuten als Sperrmittel zwischen den Leiterbahnen des Trägers ist für das Verarbeiten von Blöcken anwendbar, da die Trägeroberfläche für die Blockmontage eben sein muss.

Die einzelnen LEDs eines Blockes müssen nach dem Aufkleben in der Richtung der Leiterbahnen auf dem Träger ganz oder zum mindesten bis auf 90% der LED-Dicke voneinander getrennt werden (siehe Fig. 4b), damit die Stromzuleitung gezielt auf Einzelelemente der Matrix gesteuert werden kann. Die totale Auftrennung ist vorteilhafter, da der notwendige Fräsenschnitt im gleichen Arbeitsgang bis in die Nut 9 auf dem Träger geführt werden kann (siehe Fig. 4c) und somit gleichzeitig auch alle eventuell vorhandenen Kurzschlüsse aufgetrennt werden. Wenn die Blöcke montiert und parallel zu den Leiterbahnen aufgetrennt sind, wird das Array in der gleichen Weise weiterverarbeitet wie ein Array, das durch Montage von einzelnen Elementen entstanden ist.

Die Vorteile der Herstellung von Arrays mit Blockmontage besteht darin, dass Arrays beliebiger Form und Grösse, vor allem auch lineare Arrays hergestellt werden können, wobei durch die vereinfachte Montage auch noch dichtere Raster als mit der Einzelchipmontage erreicht werden können.

Die mit dem erfindungsgemässen Verfahren hergestellten LED-Arrays können dank ihrer hohen Packungsdichte zu sehr kleinen Anzeigen mit hoher Bildqualität verarbeitet weden. Um die Vorteile der Kleinheit und der Qualität auf die ganze Anzeige voll übertragen zu können, hat der Träger vorzugsweise auch auf seiner Unterseite Leiterbahnen, die zu den Leiterbahnen auf der Oberseite orthogonal, zu den Bonddrähten auf der LED-Oberseite aber parallel verlaufen. Diese Leiterbahnen sind am Rande der Matrix mit den Verbindungsdrähten oder den Schichtverbindungen der LED-Oberseiten verbunden. Eine solche Anordnung erlaubt es, die Matrix von beiden Seiten mit Strom zu speisen. Wenn also in einer Spalte ein Bonddraht defekt ist, kann trotzdem noch die ganze Spalte mit Strom versorgt werden. Die Anordnung der Speiseanschlüsse auf zwei Seiten des Trägers erlaubt eine relativ einfache Verbindung mit weiteren Schaltungen. Die Ansteuerelektronik wird vorteilhaft auf einem ähnlichen Träger leicht versetzt unterhalb des LED-Arrays angebracht, was zu einer sehr kompakten Bauweise führt. Es ist vorteilhaft, Anzeigen, die eine sehr kompakte Bauweise aufweisen, beispielsweise als Anzeigen von Feuerleitinformation in Waffensystemen einzusetzen, da diese dadurch ergonomisch im Gesichtsfeld des Richtschützen eingeblendet werden können.

## Patentansprüche

1. Verfahren zur Herstellung elektronischer Hybridschaltungen mit matrixförmiger oder gruppierter Anordnung von Funktionselementen (4) in hoher Packungsdichte auf einem Substrat (1), auf dem in Zonen der Elementenanordnung Sperrmittel (3,9) geschaffen werden, zwischen welchen die Funktionselemente (4) mittels elektrisch leitendem Klebstoff (6) auf das Substrat (1) aufkontaktiert werden, dadurch gekennzeichnet, dass die beim kleben entstehenden, unerwünschten, über die Sperrmittel (3,9) sich erstreckenden elektrischen Kontakte durch eine mechanische Trennung des den Kontakt bildenden Materials aufgetrennt werden, wobei der Trennschnitt (7) bis in das Sperrmittel (3,9) hinein geführt wird.

2. Verfahren nach Anspruch 1, dadurch gekennzeichnet, dass die Sperrmittel auf dem Substrat (1) zwischen nebeneinander verlaufenden Leiterbahnen (2) angebracht werden.

3. Verfahren nach Anspruch 2, dadurch gekennzeichnet, dass als Sperrmittel auf dem Substrat verlaufende Erhöhungen (3) aus einem elektrisch isolierenden Material, das dem für die Aufkontaktierung verwendeten Klebstoff (6) in seinen Eigenschaften in bezug auf eine mechanische Bearbeitung möglichst ähnlich ist, gebildet werden.

4. Verfahren nach Anspruch 3, dadurch gekennzeichnet, dass als Klebstoff (6) zur Aufkontaktierung mit Silber versetztes Epoxydharz und zur Bildung der Erhöhungen (3) Polyimid verwendet wird.

5. Verfahren nach Anspruch 2, dadurch gekennzeichnet, dass als Sperrmittel Nuten (9) in das Substrat (1) eingebracht werden.

6. Verfahren nach einem der Ansprüche 1 bis 5, dadurch gekennzeichnet, dass die Funktionselemente (4) einzeln auf das Substrat (1) aufkontaktiert werden.

7. Verfahren nach Anspruch 5, dadurch gekennzeichnet, dass die Funktionselemente (4) in Form von integrierten Blöcken, die aus einem Herstellungswafer herausgeschnitten sind, auf das Substrat (1) aufkontaktiert werden.

8. Verfahren nach Anspruch 7, dadurch gekennzeichnet, dass Blöcke mit Seitenlängen von m und n Funktionselementen verwendet werden, wobei m und n entweder ganzzahlige, nichtnegative Potenzen von 2 oder ganzzahlige Teiler der Zahl der Funktionselemente entlang der Seitenlängen des herzustellenden Arrays sind.

9. Verfahren nach einem der Ansprüche 7 oder 8, dadurch gekennzeichnet, dass die Blöcke nach dem Aufkontaktieren mittels Klebstoff (6) durch einen Trennvorgang, der durch den Klebstoff (6) hindurch und bis in die Nut (9) geführt ist, elektrisch voneinander getrennt werden.

10. Verfahren nach einem der Ansprüche 1 bis 9, dadurch gekennzeichnet, dass die einzelnen Funktionselemente (4) auf ihrer vom Substrat (1) abgewandten Seite mit entsprechenden kontaktierungsflächen (5) ausgestattet sind und dass diese kontaktierungsflächen (5) durch Drähte (8), die mit Hilfe des Multistitch-Bonding-Verfahrens angebracht werden, miteinander verbunden werden.

11. Verfahren nach einem der Ansprüche 1 bis 9, dadurch gekennzeichnet, dass die einzelnen Funktionselemente (4) auf ihrer vom Substrat (1) abgewandten Seite mit kontaktierungsflächen (5) ausgestattet sind, und dass diese kontaktierungsflächen (5) mit Schichtverbindungen (12), die auf photochemischem Weg hergestellt werden, verbunden werden.

12. Verfahren nach einem der Ansprüche 10 oder 11, dadurch gekennzeichnet, dass das Substrat (1) auf der von den Funktionselementen (4) abgewandten Seite mit Leiterbahnen ausgestattet ist, die parallel laufen zur Verbindung (8,12) der Funktionselemente (4) an deren vom Substrat (1) abgewandten Oberfläche, und dass diese Leiterbahnen mit der Verbindung (8,12) der Funktionselemente (4) parallelgeschaltet werden.

13. Anwendung des Verfahrens nach einem der Ansprüche 1 bis 12 zur Herstellung eines LED-Arrays mit hoher Packungsdichte.

## Claims

1. Method for the manufacture of electronic hybrid circuits with matrix-shaped or grouped arrangement of function elements (4) at a high packing density on a substrate (1), on which blocking means (3, 9) are created in zones of the element arrangement, between which the function elements (4) are contacted on to the substrate (1) by means of electroconductive adhesive (6), characterized in that the unwanted electrical contacts arising during adhesion and extending over the blocking means (3, 9) are interrupted by a mechanical separation of the material forming the contact, with the separating cut (7) being guided up to and into the blocking means (3, 9).

2. Method according to claim 1, characterized in that the blocking means are applied to the substrate (1) between printed conductors (2) extending next to one another.

3. Method according to claim 2, characterized in that there are formed as blocking means elevations (3), extending on the substrate, of an electrically insulating material which, in its properties with respect to a mechanical processing, is as similar as possible to the adhesive (6) used for the contacting.

4. Method according to claim 3, characterized in that epoxy resin mixed with silver is used as adhesive (6) for the contacting and polyimide is used for the formation of the elevations (3).

5. Method according to claim 2, characterized in that grooves (9) are introduced into the substrate (1) as blocking means.

6. Method according to one of claims 1 to 5, characterized in that the function elements (4) are contacted individually on to the substrate (1).

7. Method according to claim 5, characterized in that the function elements (4) are contacted on to the substrate (1) in the form of integrated blocks which are cut out from a production wafer.

8. Method according to claim 7, characterized in that blocks with side lengths of m and n function elements are used, with m and n either being integral, non-negative powers of 2 or integral dividers of the number of function elements along the side lengths of the array to be manufactured.

9. Method according to one of claims 7 or 8, characterized in that after the contacting by means of adhesive (6) the blocks are electrically separated from one another by a separating process, which is guided through the adhesive (6) and up to and into the groove (9).

10. Method according to one of claims 1 to 9, characterized in that the individual function elements (4) are equipped on their side away from the substrate (1) with appropriate contacting faces (5) and in that these contacting faces (5) are connected to one another by wires (8) which are applied with the aid of the multi-stitch bonding method.

11. Method according to one of claims 1 to 9, characterized in that the individual function elements (4) are equipped with contacting faces (5) on their side away from the substrate (1), and that these contacting faces (5) are connected by layer connections (12) which are produced by photochemical means.

12. Method according to one of claims 10 or 11, characterized in that the substrate (1) is equipped with printed conductors on the side away from the function elements (4), the printed conductors running parallel to the connection (8, 12) of the function elements (4) at the surface away from the substrate (1), and in that these printed conductors are connected in parallel with the connection (8, 12) of the function elements (4).

13. Application of the method according to one of claims 1 to 12 for the manufacture of a LED array with high packing density.

## Revendications

1. Procédé de fabrication de circuits électroniques hybrides en forme de matrice ou de montage groupé d'éléments fonctionnels (4) à forte densité de charge sur un substrat (1) sur lequel on a créé des moyens de blocage (3, 9) dans les zones du montage des éléments, et entre ces moyens de blocage, on met en contact les éléments fonctionnels (4) à l'aide de colle (6) conductrice d'électricité, sur le substrat (1), procédé caractérisé en ce que l'on ouvre les contacts électriques non voulus résultant du collage et qui passent par dessus les moyens de blocage (3, 9) par une séparation mécanique de la matière formant le contact et en ce qu'on réalise la coupe de séparation (7) jusque dans le moyen de blocage (3, 9).

2. Procédé selon la revendication 1, caractérisé en ce que les moyens de blocage sont réalisés sur le substrat (1) entre les chemins conducteurs (2) juxtaposés.

3. Procédé selon la revendication 2, caractérisé en ce que les moyens de blocage sont des surélévations (3) formés sur le substrat, ces surélévations étant réalisées en une matière isolante électrique qui est analogue dans ses caractéristiques d'usinage mécanique à la colle (6) utilisée pour la mise en contact.

4. Procédé selon la revendication 3, caractérisé en ce que la colle (6) pour la mise en contact est une résine epoxy contenant de l'argent tandis que pour former les surélévations (3), on utilise une polyimide.

5. Procédé selon la revendication 2, caractérisé en ce que comme moyens de blocage, on réalise des rainures (9) dans le substrat (1).

6. Procédé selon l'une des revendications 1 à 5, caractérisé en ce qu'on met les éléments fonctionnels (4) en contact, un à un sur le substrat (1).

7. Procédé selon la revendication 5, caractérisé en ce qu'on met en contact sur le substrat (1), les éléments fonctionnels (4) sous la forme de blocs intégrés eux-mêmes découpés dans une plaquette de fabrication.

8. Procédé selon la revendication 7, caractérisé en ce qu'on utilise des blocs dont les côtés ont une longueur de m et de n éléments fonctionnels, m et n étant soit des puissances entières non négatives de 2 ou des quotients entiers du nombre d'éléments fonctionnels le long des côtés du réseau à réaliser.

9. Procédé selon l'une des revendications 7 ou 8, caractérisé en ce qu'après mise en contact avec de la colle (6), on sépare électriquement les blocs par une opération de séparation traversant la colle (6) et conduite jusque dans la rainure (9).

10. Procédé selon l'une des revendications 1 à 9, caractérisé en ce qu'on munit les différents éléments fonctionnels (4), sur leur face opposée au substrat (1), avec des surfaces de contact (5) correspondantes et en ce que l'on relie ces surfaces de contact (5) par des fils (8) qui sont mis en place selon le procédé de collage à points multiples.

11. Procédé selon l'une des revendications 1 à 9, caractérisé en ce qu'on munit les éléments fonctionnels (4) distincts, sur leur face opposée au substrat (1), de surfaces de contact (5) et on relie ces dernières par des liaisons par couche (12) obtenues selon un procédé photochimique.

12. Procédé selon l'une des revendications 10 ou 11, caractérisé en ce que le substrat (1) comporte sur sa face opposée à celle des éléments fonctionnels (4), les chemins conducteurs parallèle à la liaison (8, 12) des éléments fonctionnels (4) au niveau de leurs surfaces supérieures opposées au substrat 1 et en ce que ces chemins conducteurs sont branchés en parallèle avec la liaison (8, 12) des éléments fonctionnels (4).

13. Application du procédé selon l'une des revendications 1 à 12 à la fabrication de réseau de diode LED à forte densité de charge (densité d'intégration).
